Europäisches Patentamt

**European Patent Office**

Office européen des brevets

(19)

(11) Veröffentlichungsnummer: **0 065 552**
**B1**

(12) **EUROPÄISCHE PATENTSCHRIFT**

(45) Veröffentlichungstag der Patentschrift:
**10.07.85**

(21) Anmeldenummer: **81903247.5**

(22) Anmeldetag: **25.11.81**

(86) Internationale Anmeldenummer:
**PCT/DE 81/00208**

(87) Internationale Veröffentlichungsnummer:
**WO 82/01968 (10.06.82 Gazette 82/15)**

(51) Int. Cl.⁴: **H 03 J 1/02, H 04 N 5/50, H 03 J 7/28**

(54) **SCHALTUNGSANORDNUNG ZUM AUTOMATISCHEN ANZEIGEN VON ALPHANUMERISCHEN SENDERKENNZEICHNUNGEN BEI RUNDFUNK- UND FERNSEHEMPFÄNGERN.**

(30) Priorität: **26.11.80 DE 3045037**
**29.01.81 DE 3103377**

(43) Veröffentlichungstag der Anmeldung:
**01.12.82 Patentblatt 82/48**

(45) Bekanntmachung des Hinweises auf die Patenterteilung:
**10.07.85 Patentblatt 85/28**

(84) Benannte Vertragsstaaten:
**DE NL**

(56) Entgegenhaltungen:
**DE - A - 2 746 186**
**DE - A - 2 813 727**
**DE - A - 2 903 944**
**FR - A - 2 411 509**
**GB - A - 2 004 429**

(73) Patentinhaber: **PETROVIC, Branko, Dip.-Ing.,
Ebersteinweg 9, D-1000 Berlin 37 (DE)**

(72) Erfinder: **PETROVIC, Branko, Dip.-Ing., Ebersteinweg 9,
D-1000 Berlin 37 (DE)**

(74) Vertreter: **Butenschön, Antje, Dr., Patentanwälte
PFENNING, MEINIG & PARTNER Kurfürstendamm 170,
D-1000 Berlin 15 (DE)**

**0 065 552**

### Beschreibung

Die Erfindung betrifft eine Schaltungsanordnung zum automatischen Anzeigen von alphanumerischen Senderkennzeichnungen bei Rundfunk- und Fernsehempfängern entsprechend dem Oberbegriff des Anspruchs 1.

Bei der Abstimmung des Empfangsoszillators in einem Rundfunkgerät wird die Kapazität eines Kondensators im frequenzbestimmenden Schwingbereich verändert. Der Kondensator ist mit einer Skala, auf der die Frequenzen und/oder die Senderstationen eingetragen sind, gekoppelt. Auf derartigen Skalen können jedoch nicht die Namen aller zu empfangenen Sender auf der Skala eingetragen werden. Sind dagegen nur Frequenzwerte angegeben, so muß mittels einer Sendertabelle jeweils der dieser Frequenz zugeordnete Sendername ermittelt werden. Letzteres ist auch bei der digitalen Abstimmung nach der Frequenzsynthese der Fall.

Aus der DE-A1-2 813 727 ist eine Schaltungsanordnung mit einer Speicheranordnung bekannt, welche Sendernamen entsprechende Informationen zusammen mit deren Trägerfrequenzen gespeichert enthält. Hierbei erfolgt ein fortlaufender Vergleich aller im Speicher enthaltenen Senderfrequenzen mit der augenblicklich eingestellten Empfangsfrequenz. Nachteilig ist dabei, daß, insbesondere bei einer größeren Anzahl von gespeicherten Sendern, dieser Vergleich eine gewisse Zeit in Anspruch nimmt, so daß die Anzeige dem Durchfahren der Senderskala nicht »zeitlos« folgen kann. Das beschriebene Prinzip ist vielmehr nur dann brauchbar, wenn die Zahl der gespeicherten Sender in einer Größenordnung liegt, wie sie auch durch Stationstasten direkt anwählbar ist. Weiterhin ist nachteilig, daß für jeden zu speichernden Sendernamen die vollständige Frequenzinformation in einem Speicher festgehalten werden muß.

Die DE-A-2 903 944 betrifft eine Einrichtung zur alphanumerischen Anzeige der Kennwerte einer mit einem Überlagerungsempfänger zu empfangenden, in einem Kanal eines Frequenzbandes liegenden Sendestation, die einen Datenspeicher, einen Datenzwischenspeicher und eine Anzeigeeinrichtung aufweist. Dabei wird die einer bestimmten Empfangsfrequenz zugeordnete Oszillatorfrequenz über eine A/D-Wandler in eine Kanaladresse umgewandelt, die in einem Adressenregister gespeichert wird. Mit diesen bestimmten Adressen wird aus dem Datenspeicher die in diesem fest eingespeicherten Kennwerte in einen Datenzwischenspeicher übertragen und in einer Anzeigevorrichtung angezeigt. Zusätzlich ist ein Empfangsbereichswähler vorgesehen, wie er bei Empfängern mit mehreren Empfangsbereichen, in denen unterschiedliche Zwischenfrequenzen verwendet werden, erforderlich ist, um die Vorgabe von zwei Frequenzteilern entsprechend dem benutzten Empfangsbereich einzustellen. Jedem Empfangsbereich ist eine Binärzahl zugeordnet, die an parallelen Eingängen eines voreinstellbaren Zählers übernommen wird. Wenn ein Torsignal gegeben wird, wird die vom Frequenzteiler gelieferte Frequenz gezählt und an den Ausgängen des Zählers erscheint die je zur augenblicklichen Empfangsfrequenz gehörige Adresse.

Der Erfindung liegt die Aufgabe zugrunde, eine Schaltungsanordnung zum Anzeigen von Sendernamen in Rundfunk- oder Fernsehempfangsgeräten anzugeben, welche beliebig viele Sendernamen enthalten kann, ohne daß ein wesentlicher Zeitverlust beim Auffinden und Anzeigen des eingestellten Senders entsteht. Insbesondere soll dabei auch der zum Festhalten der Sendernamen notwendige Speicheraufwand und der Aufwand an Bauelementen geringer gehalten sein.

Diese Aufgabe wird durch die im Anspruch 1 gekennzeichneten Merkmale gelöst.

Für jede empfangene Station muß nicht ein vollständiger Frequenzwert in einem Speicher vorhanden sein, sondern lediglich eine Information, die zur Adressierung des die Senderbezeichnung enthaltenden Speicherplatzes ausreichend ist. Sind Sender- oder Programmbezeichnungen mehrfach vorhanden, so läßt sich durch Mehrfachadressierung derselben Bezeichnung weiterer Speicherraum einsparen. Durch Vorsehen des voreinstellbaren Zählers, der mit einer Matrix verbunden ist, sind Umsetzmittel vorgesehen, welche die jeweiligen Frequenzbereiche durch Frequenzdifferenzbildung an den Adressierungsbereich des weiteren Speichers so anpassen, daß der erhaltene Bereich der Frequenzwerte den zur Verfügung stehenden vorgesehenen Adressierungsbereich, am Speicheranfang beginnend, überdeckt. Die durch die Anzahl der vorgesehenen Speicheradressen bestimmte »Auflösung« ist an das Frequenzraster der notwendigen Abstimmgenauigkeit bezogen auf den jeweiligen Frequenzbereich angepaßt.

Das sich aufgrund der vorhandenen Adressen ergebende Frequenzraster ist dabei bevorzugt auf die durch die internationalen, die Wellenpläne betreffenden Übereinkommen festgelegte Dichte der Senderverteilung derart abgestimmt, daß jeweils an der Grenze eines »Empfangskanals« die Adressierung eines anderen Speicherplatzes für Sendernamen erfolgt. Erreicht wird diese »Synchronisation« dadurch, daß eine Differenzbildung der Empfangsfrequenz in einem dem Frequenzraster des Wellenplans entsprechenden Verhältnis erfolgt.

Es lassen sich beispielsweise auch Frequenztoleranzen in günstiger Weise dadurch ausgleichen, daß in dem weiteren Speicher für einzelne benachbarte Frequenzen identische Adressen des Speichers für die Sendernamen enthalten sind.

Dazu kommt, daß der Speicher für die Sendernamen dadurch praktisch redundanzfrei aufgebaut sein kann, daß (erstens) Speicher mit Speicherplätzen unterschiedlicher Größe vorgesehen sind, in denen jeweils Sendernamen mit gleicher oder ähnlicher Wortlänge festgehalten sind, und daß (zwei-

2

0 065 552

tens) Namen für die unterschiedlichen Programme der Sendeanstalten, die von Senderketten abgestrahlt werden, als »Sendernamen« nur einmal vorhanden sein müssen und von verschiedenen Frequenzen nach der in dem weiteren Speicher getroffenen Zuordnung adressierbar sind. Diese Anordnung hat weiterhin den Vorteil, daß sämtliche in einem größeren geographischen Bereich hörbare Rundfunkprogramme in dem ersten Speicher festgehalten sein können, während die Zuordnung der in einer bestimmten Region hörbaren Sender durch Änderung des Inhalts des weiteren (zweiten) Speichers erfolgt. Hierdurch ist die zu verändernde Speicherkapazität sehr viel kleiner, so daß lokal unterschiedliche »Austausch-PROMs« mit geringem Aufwand herstellbar sind. Es läßt sich auch eine Anpassung an lokale Verhältnisse günstig in der Weise erzielen, daß durch zusätzliche wahlweise einschaltbare RAM-Speichermittel einzelne fest in dem ROM-Speicher festgehaltene Zuordnungen durch willkürliche Zuordnungen ersetzt werden.

Um eine Anpassung auch an die örtlichen Empfangsverhältnisse zu gewährleisten, können gegebenenfalls auch die die Sendernamen enthaltenden, bevorzugt zusammen mit dessen Adressierung bewirkenden Speichern steckbar (als PROM-Speicher) ausgeführt werden, so daß ohne weiteres eine Bestückung entsprechend dem Lieferland vorgenommen werden kann und auch dem Benutzer bei Reisen, Umzügen und dergleichen eine entsprechende Änderung ohne besondere Schwierigkeiten möglich ist. Für die Änderung durch den Benutzer ist die Ausbildung der Speicher in Form von ohne zusätzliche Werkzeuge handhabbaren Steckmodulen zweckmäßig.

Eine Anpassung an die örtlichen Empfangsgegebenheiten wird bei einer anderen Ausführung der Erfindung insbesondere auch dadurch erreicht, daß parallel zu den fest eingespeicherten Sendernamen in parallelen RAM-Speichern weitere Sendernamen durch äußere Eingabemittel (anschließbares Tastenfeld oder dergleichen) solche Sendernamen programmierbar sind, die bei Einstellung der zugehörigen Frequenz anstelle der festeingespeicherten Namen erscheinen. Auf diese Weise lassen sich Unterschiede bezüglich der empfangenen Sender am Empfängerstandort in Bezug auf den größeren örtlichen Bereich vornehmen, für den der Empfänger vorgesehen ist. Statt einzelner Ländernamen kann auch die die Zuordnung von Empfangsfrequenz und Speicherplatz für den Sendernamen bildende Adresse in dem zweiten Speicher durch einen parallelen RAM-Speicher »überschreibbar« gestaltet werden, so daß insbesondere bei Senderketten, die ein einziges Programm ausstrahlen, die Zuordnung von Empfangsfrequenz und Programmbezeichnung mit geringstem Speicheraufwand verändert werden kann. Der pro empfangenen Programm zu verändernde Speicherinhalt entspricht bei dieser Ausführungsform der Erfindung lediglich einer solchen Information, welche notwendig ist, um eine Programmbezeichnung innerhalb einer vorhandenen »Programmtabelle« eindeutig zu identifizieren. Diese Anordnung ist auch dann hilfreich, wenn neben starken Hauptsendern regionale Füllsender vorhanden sind.

Wie aus dem Vorstehenden ersichtlich, ist die Erfindung auch dann vorteilhaft anwendbar, wenn bei dichter Belegung der Frequenzbereiche mit Sendern — wie es insbesondere in dicht bevölkerten Regionen zunehmend der Fall ist — nahezu jedem Empfangskanal im vom Wellenplan festgelegten Frequenzraster — vorzugsweise im Lang-, Mittel- und Kurzwellenbereich ein Sender hörbar ist, so daß damit die Adressierung durch den zusätzlichen zweiten Speicher redundanzfrei ist. Bei UKW-Sendernetzen sind zwar am jeweiligen Empfangsort — bedingt durch die unterschiedlichen Ausbreitungsbedingungen — weniger Sender hörbar, dafür ist aber auch die Zahl der Kanäle pro Empfangsbereich wegen der breitbandigeren Übertragung herabgesetzt, so daß auch dann, wenn für alle vorkommenden Empfangsfrequenzen eine Adressiermöglichkeit besteht, der Speichermehraufwand gering ist. Letzterer läßt sich reduzieren, wenn für bestimmte Empfangsgebiete spezielle Speicher gefertigt werden, wobei nicht belegte Frequenzgebiete sowohl im ersten als auch im zweiten Speicher nicht berücksichtigt zu werden brauchen. Da die Zuordnungen bevorzugt für die verschiedenen Frequenzbereiche, in einzelnen Speicherbausteinen zusammengefaßt, verschieden getroffen werden können, ist eine optimale Anpassung an alle Gegebenheiten möglich. Insbesondere ist die Erfindung auch für kombinierte Rundfunk- und Fernsehempfänger wie für das sogenannte »Satellitenfernsehen« vorbereitete Empfänger günstig verwendbar.

Weitere vorteilhafte Weiterbildungen der Erfindung sind in den übrigen Unteransprüchen angegeben.

Die Erfindung wird nachstehend anhand eines in der Zeichnung dargestellten Ausführungsbeispiels erläutert. Es zeigt

Fig. 1 ein Blockschaltbild eines Ausführungsbeispiels und

Fig. 2 eine Zusatzschaltung für das Ausführungsbeispiel gemäß Fig. 1.

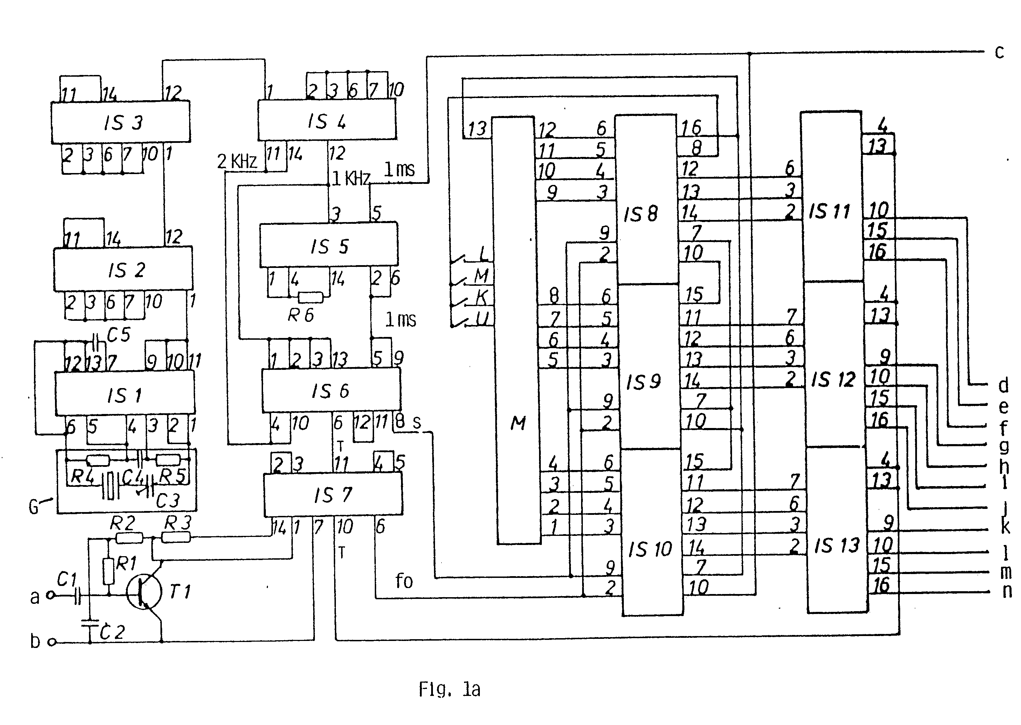

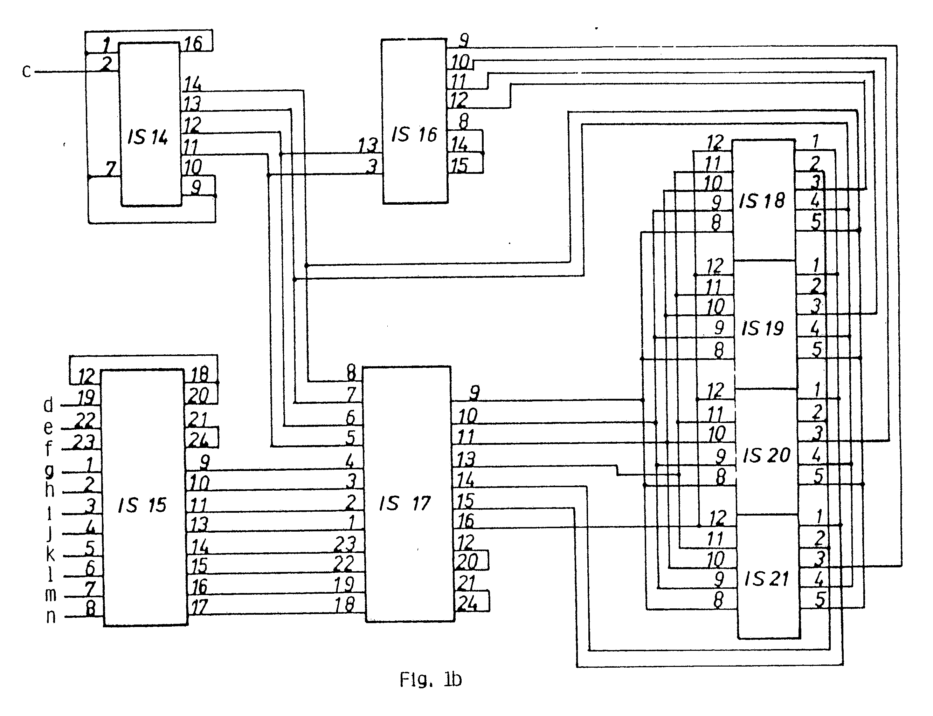

Das in Fig. 1 dargestellte Ausführungsbeispiel enthält folgende Bauelemente:

| 1. | IS | 1 | SN 7400 | (4 NAND-Glieder mit 2 Eingängen) |
|----|----|---|---------|-----------------------------------|
| 2. | IS | 2 | SN 7490 | (Dezimalzähler) |
| 3. | IS | 3 | SN 7490 | (Dezimalzähler) |
| 4. | IS | 4 | SN 7490 | (Dezimalzähler) |
| 5. | IS | 5 | SN 7474 | (D-Flip-Flop) |
| 6. | IS | 6 | SN 7410 | (3 NAND-Glieder mit 3 Eingängen) |
| 7. | IS | 7 | SN 7404 | (sechsfacher Inverter) |

3

| | | | |
|---|---|---|---|
| 8. | IS 8 | SN 74161 | (synchroner 4-bit-Binärzähler) |
| 9. | IS 9 | SN 74161 | (synchroner 4-bit-Binärzähler) |
| 10. | IS 10 | SN 74161 | (synchroner 4-bit-Binärzähler) |
| 11. | IS 11 | SN 7475 | (D-Flip-Flop) |
| 12. | IS 12 | SN 7475 | (D-Flip-Flop) |
| 13. | IS 13 | SN 7475 | (D-Flip-Flop) |
| 14. | IS 14 | SN 74161 | (synchroner 4-bit-Binärzähler) |
| 15. | IS 15 | HN 462716 | (2K-byte EPROM-Speicher) |
| 16. | IS 16 | SN 74155 | (2-bit Demultiplexer) |
| 17. | IS 17 | TMS 2532 | (4K-byte EPROM-Speicher) |
| 18. | IS 18 | DL 1414 | (4stellige 16-Segment LED Anzeige mit Dekoder) |
| 19. | IS 19 | DL 1414 | (4stellige 16-Segment LED Anzeige mit Dekoder) |
| 20. | IS 20 | DL 1414 | (4stellige 16-Segment LED Anzeige mit Dekoder) |
| 21. | IS 21 | DL 1414 | (4stellige 16-Segment LED Anzeige mit Dekoder) |
| 22. | G | | Oszillator, 1 MHz |

Der Oszillator G erzeugt eine Frequenz von 1 MHz, die über die NAND-Glieder IS 1 an den Eingang des Zählers IS 2 (pin 1) geführt wird, der die Frequenz im Verhältnis von 10 : 1 teilt. Vom Ausgang des Zählers IS 2 (pin 12) wird die Frequenz an den Eingang des Zählers IS 3 (pin 1) weitergeführt, der die Frequenz ebenfalls im Verhältnis 10 : 1 teilt. Vom Ausgang IS 3 (pin 12) wird die Frequenz dem Eingang des Zählers IS 4 (pin 1) geführt, der die Frequenz auch um 10 : 1 herabsetzt. Das gesamte Teilungsverhältnis beträgt damit 1000 : 1. Vom Ausgang des Zählers IS 4 (pin 12) wird die Frequenz an den Eingang des D-Flip-Flops IS 5 (pin 3) geführt. An dessen Ausgängen (pin 6, 2 und 5) entstehen Impulse, die eine Impulslänge von 1 ms haben. Diese Impulslänge ist günstig, weil damit der binäre Zähler IS 8, 9, 10 die Oszillatorfrequenz des Empfängers in Kilohertz zählen kann. Durch Variation der Zählzeit und/oder des Teilungsverhältnisses läßt sich eine Anpassung an durch den Wellenplan vorgegebene Frequenzraster erreichen.

Vom Ausgang der integrierten Schaltung IS 5 (pin 5) werden die Impulse an den Eingang des binären Zählers IS 10 (pin 10) geführt. Mit diesen Impulsen wird die Zählzeit bestimmt, sie gelangen auch an den Eingang des Zählers IS 14 (pin 2).

Vom Ausgang der integrierten Schaltung IS 4 (pin 11 mit einer Frequenz von 2 kHz und pin 12 mit einer Frequenz von 1 kHz) sowie von der integrierten Schaltung IS 5 (pin 6) werden die Impulse an die Eingänge der integrierten Schaltung IS 6 (pin 1, 4, 5) geführt. An den Ausgängen der integrierten Schaltung IS 6 (pin 6) entstehen T-(Takt-) und an pin 8 S-(Stell-)Impulse.

Der T-Impuls am Ausgang der integrierten Schaltung IS 6 (pin 6) wird über die integrierte Schaltung IS 7 (pin 10) an die Eingänge des Speichers IS 11, 12, 13 (pin 4, 13) geführt. Mit diesem Impuls werden die Daten aus dem binären Zähler IS 8, 9, 10, in die Speicher IS 11, 12, 13 übertragen.

Der S-Impuls am Ausgang der integrierten Schaltung IS 6 (pin 8) wird dem Eingang des binären Zählers IS 8, 9, 10 (pin 9) zugeführt. Mit diesem Impuls werden die Daten aus einer Matrix M, mit der die Voreinstellung des Zählers IS 8, 9, 10 bestimmt wird, in den binären Zähler IS 8, 9, 10 (pin 3, 4, 5, 6) übertragen.

Die Oszillatorfrequenz des Empfängers wird den Klemmen a, b zugeführt und gelangt über einen Transistor T1 und die integrierte Schaltung IS 7 (pin 6) an die Takteingänge des binären Zählers IS 8, 9, 10 (pin 2).

Die Ausgänge des Zählers IS 8, 9, 10 (pin 11, 12, 13, 14) sind mit den Eingängen des Speichers IS 11, 12, 13 (pin 2, 3, 6, 7) verbunden, während die Ausgänge des Speichers IS 11, 12, 13 (pin 9, 10, 15, 16) an die Adresseneingänge des 2K-byte ROM Speichers IS 15 (pin 1, 2, 3, 4, 5, 6, 7, 8, 19, 22, 23) angeschlossen sind.

Die Ausgänge des Speichers IS 15 (pin 9, 10, 11, 13, 14, 15, 16, 17) führen zu den Adresseneingängen des 4K-byte ROM-Speichers IS 17 (pin 4, 3, 2, 1, 23, 22, 19). Die ersten vier Adresseneingänge des Speichers IS 17 (pin 5, 6, 7, 8) sind mit den Ausgängen des binären Zählers IS 14 (pin 11, 12, 13, 14) verbunden.

An die Ausgänge des Speichers IS 17 (pin 9, 10, 11, 13, 14, 15, 16) sind die Adresseneingänge des Indikators IS 18, 19, 20, 21 (pin 1, 2, 8, 9, 10, 11, 12) angeschlossen.

Der Ausgang pin 11 des Zählers IS 14 führt an den Eingang pin 3 des Demultiplexers IS 16, entsprechend der Ausgang pin 12 an den Eingang pin 13. Die Ausgänge des Demultiplexers IS 16 (pin 9, 10, 11, 12) sind je mit pin 3 des Indikators IS 18, 19, 20, 21 verbunden. Die Ausgänge pin 13 und 14 des Zählers IS 14 führen außerdem zu Eingängen pin 4, 5 des Indikators IS 18, 19, 20, 21.

Die Wirkungsweise der Anordnung ist folgende:

Die Oszillatorfrequenz des zugehörigen Empfängers wird über die Klemmen a, b, den Transistor T1 und die integrierte Schaltung IS 7 (pin 6) an den binären Zähler IS 8, 9, 10 geführt, der die Frequenz in Kilohertz zählt.

Für den UKW-Bereich kann man zwischen Transistor T1 und der integrierten Schaltung IS 7 einen Teiler 20 : 1 einsetzen, um zwischen den Sendern einen Frequenzschritt von 5 kHz zu bekommen. Für den Fernsehbereich ist zwischen Transistor T1 und der integrierten Schaltung IS 7 ein Teiler 1000 : 1

4

einzusetzen, um zwischen den Sendern einen Frequenzgang von 7 bzw. 8 kHz zu erhalten. Diese Teiler sind in der Zeichnung nicht mit angegeben.

Wenn der Ausgang der integrierten Schaltung IS 5 (pin 2, 6) einen Impuls mit H-Pegel liefert (an pin 5 ist dann der Impuls mit L-Pegel), entstehen an den Ausgängen der integrierten Schaltung IS 6 (pin 6 und 8) die Steuerimpulse T und S.

Der Impuls T entsteht nur während der ersten Hälfte des Impulses am Eingang der integrierten Schaltung IS 6 (pin 5, 9). Diese Zeitlage wird mit den Impulsen an den Eingängen der integrierten Schaltung IS 6 (pin 1 und pin 4) bestimmt.

Während der zweiten Hälfte des Impulses am Eingang der integrierten Schaltung IS 6 (pin 5, 9) entsteht an der integrierten Schaltung IS 6 (pin 8) ein S-Impuls.

Mit der Reihenfolge der T- und S-Impulse wird bestimmt, daß die Daten vom binären Zähler IS 8, 9, 10 zunächst in die Speicher IS 11, 12, 13 übernommen werden, und danach werden die Daten aus der Matrix M in die Zähler IS 8, 9, 10 übernommen.

Solange die Impulse T und S wirken, zählt der Zähler IS 8, 9, 10 nicht, weil die integrierte Schaltung IS 10 (pin 10) einen L-Impuls führt.

Wenn an der integrierten Schaltung IS 5 (pin 5) ein Impuls mit einem H-Pegel ansteht — an pin 2, 6 ist jetzt ein Impuls mit einem L-Pegel —, zählt der Zähler IS 8, 9, 10 die Frequenz, die an dessen Eingangspunkt pin 2 ankommt.

Die binäre Zahl der Oszillatorfrequenz des Empfängers, die an den Ausgängen pin 9, 10, 15, 16 des Speichers IS 11, 12, 13 ansteht, muß für die niedrigste Frequenz im Wellenbereich gleich Null sein. Diese Bedingung wird mit der Voreinstellung des Zählers IS 8, 9, 10 durch die Matrix M erzielt. Die Voreinstellung, die für jeden Wellenbereich durchgeführt wird, geschieht auf folgende Weise:

Das Frequenzband im LW-, MW- und KW-Bereich läuft von 150 kHz bis 26 MHz. Weiter oben wurde festgestellt, daß im UKW-Bereich ein Teiler 20 : 1 zwischen T1 und IS 7 eingesetzt werden kann. Dies bedeutet, daß am Ausgang des Teilers ein Frequenzband von 4,375 bis 5,4 MHz erscheint. Das bedeutet, daß die obere Arbeitsfrequenz 26 MHz beträgt.

Um die Frequenz von 26 MHz zählen zu können, sind vier binäre 4-bit-Zähler erforderlich. Der letzte Ausgang des Zählers (32 768 kHz) wird nicht benötigt, weil die obere Arbeitsfrequenz niedriger ist. Damit beträgt die obere Grenzfrequenz des Zählers 32 767 kHz.

Damit der Zähler IS 8, 9, 10 an seinen Ausgängen eine binäre Null ausgibt, muß für die niedrigste Frequenz im Wellenbereich die nächste Bedingung erfüllt sein:

$$f_v = f_{gz} - f_{uo}, \text{ dabei ist:}$$

$f_v$  —  die Zahl der Frequenz, auf die der Zähler voreingestellt werden muß.

$f_{gz}$  —  die Zahl der oberen Grenzfrequenz des Zählers (32 767 kHz).

$f_{uo}$  —  die Zahl der niedrigsten Oszillatorfrequenz des Empfängers im Wellenbereich.

Unter der Annahme, daß die ZF des Empfängers 455 kHz ist, folgt:

für das LW-Band $f_v$ = 32 767 — (150 + 455) = 32 162 kHz.

Die binäre Zahl 32 162 bilden die Ausgänge des Zählers: 16 384; 8 192; 4 096; 2 048; 1 024; 256; 32; 2 (mit H-Pegel).

Für das MW-Band gilt:
Der Speicher IS 15 ist auch für das MW-Band vorgesehen. Für die erste Adresse im MW-Bereich steht die Adresse 140 zur Verfügung.

$$f_v = 32\,767 + 140 - (520 + 455)\,\text{kHz} = 31\,932\,\text{kHz.}$$

Die binäre Zahl 31 932 bildet die Ausgänge des Zählers: 16 384; 8 192; 4 096; 2 048; 1 024; 128; 32; 16; 8; 4.

Für das KW-Band gilt:
Der Speicher IS 15 ist auch für das KW-Band vorgesehen. Die erste Adresse im KW-Bereich bildet die Adresse 1 229.

$$f_v = 32\,767 + 1229 - (5950 + 455)\,\text{kHz} = 27\,591\,\text{kHz.}$$

Für den Speicher IS 15 wurde der 2K-byte ROM Speicher gewählt (2 048 × 8 bit), der 11 Adresseneingänge hat (A0 bis A10). Die Steuerung des Speichers IS 15 ist mit drei binären 4-bit-Zählern möglich, obwohl die Rechnung für Voreinstellung mit vier binären 4-bit-Zählern durchgeführt werden muß.

Die Ausgänge des binären Zählers IS 8, 9, 10 (pin 11, 12, 13, 14) sind, über den Speicher IS 11, 12, 13 (pin 9, 10, 15, 16), mit den Adresseneingängen des 2K-byte ROM-Speichers IS 15 (pin 1, 2, 3, 4, 5, 6, 7, 8, 19, 22, 23) verbunden. Der Speicher IS 11, 12, 13 beseitigt ein Flimmern der Buchstaben am Indikator IS 18, 19, 20, 21.

Der Speicher IS 15 hat zwei Aufgaben: er bestimmt die Adresse des Speichers IS 17 und verhindert den Einfluß der Frequenzabweichung des Empfängeroszillators auf die genauen Anzeigen des Indikators, die auf Temperaturänderungen oder eine ungenaue Einstellung eines Senders zurückzuführen ist.

Durch das Programm des Speichers IS 15 sind die Ausgänge festgelegt worden, die für die bestimmten Adressengruppen gleiche binäre Zahlen zeigen müssen.

Die beiden Aufgaben des Speichers IS 15 sind im einzelnen die folgenden:

1. Es sollen die Einflüsse, die von Änderungen der Oszillatorfrequenz des Empfängers herrühren, auf die genaue Anzeige des Indikators IS 18, 19, 20, 21 beseitigt werden. Diese erfolgt über die Anwendung der freien Adressen des Speichers IS 15.

Der Sender »Deutschlandfunk«, im LW-Bereich, sendet auf 155 kHz. Die niedrigste Frequenz in diesem Bereich ist 150 kHz. Mit der Voreinstellung wurde erreicht, daß der binäre Zähler IS 8, 9, 10 für die niedrigste Frequenz an seinen Ausgängen pin 11, 12, 13, 14 eine binäre Null anzeigt. Für die Sendefrequenz 155 kHz soll der Zähler IS 8, 9, 10 an seinem Ausgang eine binäre 5 aufweisen. Der nächste Sender »Radio France« sendet auf 164 kHz. Bei dieser Frequenz soll der Zähler IS 8, 9, 10 eine binäre 14 ausgeben. Diese Zahlen 5 und 14 sind gleichzeitig Adressenzahlen des Speichers IS 15. Zwischen diesen beiden Adressen, bleiben die Adressen 6, 7, 8, 9, 10, 11, 12, 13 frei.

Für den Fall, daß die Frequenz des Oszillators des Empfängers um 1 kHz niedriger ist, gilt: Der Zähler IS 8, 9, 10 beim Sender »Radio France« zeigt jetzt eine binäre 13 an. Mit dem Programm des Speichers IS 15 wurde erreicht, daß der Ausgang des Speichers IS 15 für die Adresse 13, wie bei der Adresse 14, die gleiche Zahl enthält. Auf diese Weise wurde bewirkt, daß der Indikator IS 18, 19, 20, 21 bei ±4 kHz noch immer denselben Sendernamen anzeigen kann.

2. Der Speicher IS 15 bestimmt die Adresse des Speichers IS 17, in dem sich die Namen der Sender befinden.

Die Sendernamen bestehen aus mehreren Buchstaben. Der Speicher IS 17 wurde so programmiert, daß für jeden Namen 16 Stellen zur Verfügung stehen. Der Name des ersten Senders befindet sich an den Adressen von 0 bis 15. Für den zweiten Sender sind die Adressen von 16 bis 31 vorgesehen usw.

Zusammen mit dem Programm des Speichers IS 17 sind die Sendernamen und die Abkürzung des Staates, dem der Sender gehört, eingespeichert worden.

Die Buchstaben des Sendernamens wurden in umgekehrter Reihenfolge eingetragen, weil der Indikator IS 18, 19, 20, 21 die Buchstaben rückwärts anzeigt, wie anhand eines Beispiels dargelegt werden soll:

| Adressen: | 15– | 14– | 13– | 12– | 11– | 10–– | 9–– | 8–– | 7–– | 6–– | 5–– | 4– | 3–– | 2––– | 1––0 |
|-----------|-----|-----|-----|-----|-----|------|-----|-----|-----|-----|-----|----|-----|------|------|
| Name: | D | E | U | T | S | C | H | L | A | N | D | F | U | N | K |

Nachfolgend wird die Steuerung des Speichers IS 17 und des Indikators IS 18, 19, 20, 21 durch den binären Zähler IS 14 und Demultiplexer IS 16 beschrieben.

Um die 16 Stellen für jeden Namen eines Senders anzeigen zu können, sind die ersten vier Adressen des Speichers IS 17 (pin 8, 7, 6, 5) mit den Ausgängen des Zählers IS 14 (pin 14, 13, 12, 11) verbunden. Die Ausgänge des Speichers IS 15 sind mit den Adresseneingängen des Speichers IS 17 wie folgt verbunden: Ausgang pin 9 (Do) mit dem Eingang pin 4 (a4), Ausgang pin 10 (dl) mit dem Eingang pin 3 (a5) usw.

Der binäre Zähler IS 14 und 2-bit Demultiplexer IS 16 steuern den multiplexen Betrieb des Speichers IS 17 und des Indikators IS 18, 19, 20, 21. Der binäre Zähler IS 14 steuert dabei gleichzeitig die Adresse des Speichers IS 17 (pin 8, 7, 6, 5). An den Ausgängen des Speichers IS 17 entstehen die Buchstaben in ASCII-Code, die in den Indikatoren IS 18, 19, 20, 21 dekodiert und angezeigt werden.

Weiter oben wurde ausgeführt, daß der Zähler IS 8, 9, 10 an seinen Ausgängen für die niedrigste Frequenz im Wellenbereich eine binäre Null ausgeben soll. In diesem Fall muß auch der Speicher IS 15 an seinen Ausgängen auch eine Null anzeigen, was mit dem Programm des Speichers IS 15 erreicht wird.

Wenn an den Ausgängen des Speichers IS 15 eine binäre Null ansteht, steuert der 4-bit Binär-Zähler IS 14 die ersten 16 Adressen des Speichers IS 17 hintereinander an. Mit diesen 16 Adressen wird der erste Sendername gezeigt.

Für den Fall, daß an den Ausgängen des Speichers IS 15 eine binäre Null steht, gilt folgendes:

Wenn an den Ausgängen des Binär-Zählers IS 14 auch eine Null steht, wird die erste Adresse des Speichers IS 17 angesteuert. Der Ausgang der integrierten Schaltung IS 16 (pin 9) (L-Pegel) wird gleichzeitig angesteuert, weil die Ausgänge des Zählers IS 14 (pin 12, 11) mit den Eingängen von IS 16 (pin 13, 3) verbunden sind. Der L-Pegel am Ausgang der integrierten Schaltung IS 16 (pin 9) schaltet den Indikator IS 21 ein. Die Ausgänge des Zählers IS 14 (pin 14, 13) steuern die erste Adresse des Indikators IS 21, weil die Ausgänge des Zählers IS 14 (pin 14, 13) mit den Adresseneingängen des

6

Indikators IS 21, 20, 19, 18 (pin 5 und pin 4) verbunden sind.

Am Ausgang des Zählers IS 14 wird mit dem nächsten Taktimpuls eine binäre Eins erscheinen (pin 14 = H-Pegel). Jetzt wird die zweite Adresse des Speichers IS 17 und die zweite Stelle des Indikators IS 21 angesteuert. Der Ausgang der integrierten Schaltung IS 16 (pin 9) bleibt unverändert, weil die Ausgänge des Zählers IS 14 (pin 12, 11) den L-Pegel führen.

Wenn der Ausgang des Zählers IS 14 eine binäre 2 angibt, werden die dritte Adresse des Speichers IS 17 und die dritte Stelle des Indikators IS 21 angesteuert. Der Ausgang der integrierten Schaltung IS 16 (pin 9) bleibt weiter auf dem L-Pegel.

Wenn am Ausgang des Zählers IS 14 eine binäre 3 ansteht, werden die vierte Adresse des Speichers IS 17 und die vierte Stelle des Indikators IS 21 angesteuert. Der Ausgang pin 9 der integrierten Schaltung IS 16 bleibt weiter auf dem L-Pegel.

Wenn der Ausgang des Zählers IS 14 auf binäre 4 gesetzt ist, wird die fünfte Adresse des Speichers IS 17 und der Eingang der integrierten Schaltung IS 16 (pin 13) angesteuert. Am Ausgang der integrierten Schaltung IS 16 (pin 10) wird der Pegel von H auf L geändert, wodurch der zweite Indikator IS 20 aktiviert wird. Die Ausgänge der integrierten Schaltung IS 14 (pin 14, 13) wurden in diesem Moment auf L-Pegel gesetzt, wodurch die erste Stelle des Indikators IS 20 angesteuert.

Weiterhin wird die Adresse des Speichers IS 17 nacheinander bis 15 angesteuert. Der Zähler IS 14 zählt nach der Zahl 15 wieder neu von 0 bis 15.

Wenn am Ausgang des Speichers IS 15 eine binäre 2 steht, steuert der Zähler jetzt die Adresse von 32 bis 47 hintereinander an. An den Adressen von 32 bis 47 des Speichers IS 17 ist der dritte Sendername gespeichert. Das Programm des Speichers IS 17 ist vorstehend angegeben.

Aus dem Programm des Speichers IS 15 erkennt man, daß für den LW-Bereich die Adressen von 0 bis 135 belegt worden sind. Für den MW-Bereich sind die Adressen von 136 bis 1226 belegt.

Für den KW-Bereich stehen die Adressen von 1227 bis 2048 zur Verfügung.

Die Kapazität des Speichers IS 17 (4K-byte) reicht für 256 Sendernamen, mit je 16 Buchstaben. Mit einer anderen Wahl des Speichers IS 17 können, falls gewünscht, auch größere Speicherkapazitäten erreicht werden.

Die erfindungsgemäße Anordnung ermöglicht die Eintragung und die automatische Anzeige aller Sendernamen mit der Abkürzung des Staates, dem der Sender gehört, in Abhängigkeit von der Oszillatorfrequenz des Empfängers.

Die Lösung ist für einen 16stelligen 16-Segment LED Indikator angegeben, wobei der Indikator vorteilhaft auch mit vier 5 × 7-Raster LED-Anzeigen aufgebaut werden kann.

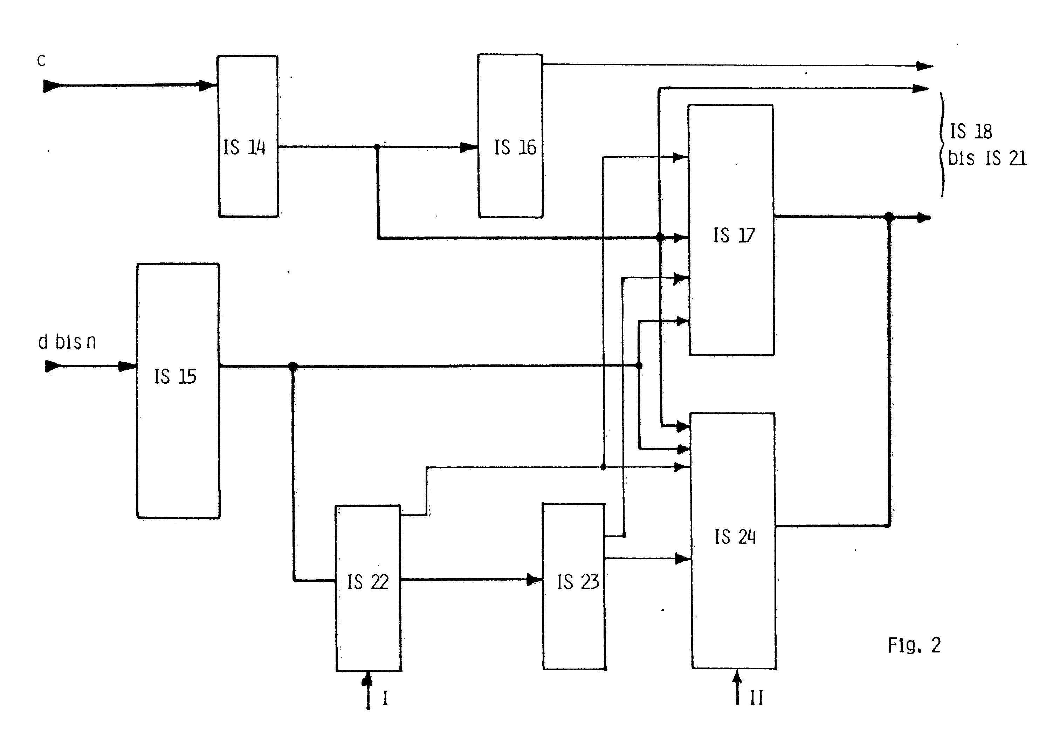

In Fig. 2 ist eine (Zusatz-) Schaltung dargestellt, welche es ermöglicht, neben den in dem EPROM-Speicher IS 17 festgehaltenen Sendernamen weitere Sendernamen einzugeben, welche alternativ zur Anzeige gebracht werden können. Damit ist es möglich, anstelle von Stationen, welche bei einer eingestellten Frequenz angezeigt werden, einen anderen Sendernamen zu bestimmen, der anstelle des ursprünglich vorgesehenen erscheint. Wenn also bei der Abstimmung ein Sender hörbar wird, der nicht demjenigen entspricht, dessen Name bzw. Kennzeichnung angezeigt wird, so ist es möglich, einen Namen einzuprogrammieren, der statt der nicht erwünschten Bezeichnung erscheinen soll. Der weitere Sendername wird in einem Schreib-Lese-Speicher festgehalten, der anstelle des entsprechenden Festwertspeichers einschaltbar ist.

Die dargestellte Anordnung umfaßt die integrierten Schaltungen IS 14, IS 15, IS 16 und IS 17 aus den Fig. 1a bzw. b. Die äußere Beschaltung entspricht der in dieser Figur dargestellten, wobei die Adressierungsleitungen zu jeweils einer (stark ausgezogenen) Leitung zusammengefaßt dargestellt sind. Zusätzlich eingefügt sind ein RAM-Speicher IS 22 (128 × 1 Bit), ein Latch IS 23, sowie ein 2 KByte-RAM-Speicher IS 24.

Der Speicher IS 22 weist für jeden Speicherbereich zur Aufnahme eines Sendernamens im Speicher IS 17 ein zugeordnetes Speicher-Bit auf, welches durch nicht dargestellte äußere Schaltmittel (Pfeil I) für jeden gemeinsam mit dem Speicher IS 17 über den Speicher IS 15 adressierten Speicherplatz individuell gesetzt bzw. zurückgesetzt werden kann. Auf diese Weise lassen sich die Speicherplätze derjenigen Stationen »markieren« bei denen der gewählte Stationsname nicht mit dem permanent gespeicherten übereinstimmt. Ist an einem Speicherplatz ein Bit »gesetzt«, so wird über das Latch IS 23 ein Signal an den RAM-Speicher IS 24 abgegeben, das diesen aktiviert, während der EPROM-Speicher IS 17 in einem inaktiven Zustand gehalten wird. An den zu den Anzeigeeinheiten IS 18 bis IS 21 führenden Leitungen (die in Fig. 2 ebenfalls zusammengefaßt dargestellt sind) erscheinen in diesem Fall die die Anzeige eines alternativen Sendernamens auslösenden Signale. Ist das entsprechende Bit im Speicher IS 22 nicht gesetzt, so wird der fest eingespeicherte, im EPROM-Speicher IS 17 vorhandene Name ausgegeben. Die alternativen Sendernamen werden über ebenfalls nicht dargestellte, durch den Pfeil II symbolisierte alphanumerische Eingabemittel in den RAM-Speicher vom Benutzer selbst IS 24 eingegeben, wenn der Speicher durch Einstellung des zugeordneten Senders adressiert ist.

Die in Fig. 2 dargestellte, aus den Bauelementen IS 22 bis 24 bestehende Anordnung kann statt auf den EPROM-Speicher IS 17 in entsprechender Weise auch auf den Speicher IS 15 angewendet werden. Bei dieser Konfiguration werden dann nicht die Sendernamen direkt, sondern deren Zuordnung zu angezeigten Frequenzen für einzelne Stationen verändert, so daß der alternative Speicherraum in einem RAM-Speicher nicht für den gesamten Sendernamen, sondern nur für dessen Adresse im EPROM-Speicher IS 17 verändert zu werden braucht. Der RAM-Speicher IS 24 kann damit kleiner ausgelegt sein. Bei der letztgenannten Konfiguration ist bevorzugt im Speicher IS 17 ein Verzeichnis aller in einem größeren Gebiet hörbaren Rundfunk- bzw. Fernsehprogramme festgehalten, während die genaue Zuordnung für regionale Anforderungen entweder durch kompletten Austausch des Speichers IS 15 oder durch Umprogrammierung einzelner Zuordnungsadressen mittels eines entsprechend beschalteten RAM-Speichers IS 22 vorgenommen wird.

Bei einer weiteren Ausführungsform der Erfindung lassen sich in Abhängigkeit von der örtlichen Aufstellung des Empfängers unterschiedliche Zuordnungen zwischen eingestellten Frequenzen und angezeigten Sendernamen realisieren. Soll der Empfänger beispielsweise an zwei unterschiedlichen Standorten betrieben werden, so wird der Speicher IS 24 in Fig. 2 als zweiter EPROM-Speicher ausgebildet, in dem die Sendernamen für einen zweiten Standort festgehalten sind. Bei einer bevorzugten Ausführungsform der Erfindung werden diejenigen Speicherbereiche in dieser Weise mehrfach vorgesehen, welche Frequenzbereichen zugeordnet sind, die bei Standortwechsel besonders starken Änderungen unterliegen, d. h. die UKW- und Fernseh- bzw. Fernsehbereiche. Anstelle der Baugruppe IS 23 ist dabei ein Umschalter vorzusehen, welcher manuell betätigbar ist und entsprechend dem Empfängerstandort jeweils einen der Speicher IS 17 oder IS 24 mit den bei den jeweiligen Frequenzen zu empfangenden Sendernamen in Abhängigkeit von seinem Schaltzustand aktiviert. Die Umschaltung kann dabei entsprechend einem dem jeweiligen Empfangsgebiet zugeordneten Code, beispielsweise Postleitzahlen, erfolgen.

Auch bei der letztgenannten Ausführungsform der Erfindung ist es besonders günstig, wenn in Abhängigkeit vom Aufstellungsort des Empfängers anstelle einer Änderung des die Sendernamen enthaltenen Speichers eine entsprechende Änderung bei der die Adressierungszuordnung bewirkenden Speichers IS 15 vorgenommen wird. Hierbei wäre die Anordnung gemäß Fig. 2 in der zuletzt beschriebenen Funktionsweise wiederum das dem Speicher IS 17 dem Speicher IS 15 zuzuordnen. Damit wären im Speicher IS 17 die Namen aller in einem größeren Gebiet empfangenden Rundfunkprogramme vorzusehen, während die Zuordnung der empfangenden Stationsfrequenzen zu den jeweiligen über den dann umschaltbaren Speicher IS 15 vorgenommen wird. Auf diese Weise ist wiederum dafür gesorgt, daß die in Abhängigkeit vom regionalen Standort des Empfängers umschaltbaren Speicher so klein wie möglich ausgelegt sein können.

Die Erfindung läßt sich damit in den unterschiedlichsten Ausführungsformen realisieren, die dem jeweiligen Anwendungszweck beim vorgesehenen Empfängertyp angepaßt ist.

## Patentansprüche

1. Schaltungsanordnung zum automatischen Anzeigen von alphanumerischen Senderkennzeichnungen bei Rundfunk- und Fernsehempfängern mit einem ersten Speicher (IS 17), der in seinen Speicherplätzen als Senderkennzeichnungen festgehaltene Informationen aufweist, mit Mitteln (IS 14, IS 16) zum Dekodieren und Übertragen der Information in einen Anzeigespeicher zur alphanumerischen Darstellung und mit einem zweiten Speicher (IS 15) zur Adressierung des ersten Speichers, wobei ein aus der momentan eingestellten Empfangsfrequenz abgeleiteter Zahlenwert mindestens mittelbar die Adresse des ersten Speichers (IS 17) bildet und die Adressierung des zweiten Speichers (IS 15) durch den erreichten Stand eines voreinstellbaren Zählers erfolgt, der jeweils für einen vorgegebenen Zeitraum durch die der augenblicklichen Empfangsfrequenz des Empfängers entsprechenden Oszillatorfrequenz getaktet und nach Ablauf des Zeitraums zurückgesetzt wird und wobei der voreinstellbare Zähler (IS 8 bis IS 10) die Oszillatorfrequenzen derart umsetzen, daß der Bereich der in dem vorgegebenen Zeitraum erscheinenden Schwingungszahlen dem Bereich der Zahlenwerte der vorgesehenen Adressen des zweiten Speichers (IS 15) entspricht, dadurch gekennzeichnet, daß die Dateneingänge des voreinstellbaren Zählers (IS 8 bis IS 10) an die Ausgänge einer Matrix (M) angeschlossen sind, in der der Wert der Frequenz, auf die der Zähler voreingestellt werden muß, für jeden Frequenzbereich festgehalten ist, wobei die Voreinstellung in der Weise erfolgt, daß die niedrigste Frequenz im Wellenbereich die binäre Zahl 0 ist.

2. Anordnung nach Anspruch 1, dadurch gekennzeichnet, daß bei den Umsetzungsmitteln (IS 8 bis IS 10) die in einem vorgegebenen Zeitraum erscheinenden Schwingungszahlen dem Bereich der Zahlenwerte der vorgesehenen Adressen des zweiten Speichers (IS 15) für ein vorgegebenes Raster von Empfangsfrequenzen entspricht.

3. Anordnung nach Anspruch 1 oder 2, dadurch gekennzeichnet, daß für einen mehrere Empfangsfrequenzbereiche aufweisenden Empfänger, die Adressen der adressierbaren Bereiche im Speicher (IS 15 bzw. IS 17) im wesentlichen lückenlos aneinandergrenzen.

4. Anordnung nach einem der Ansprüche 1 bis 3, dadurch gekennzeichnet, daß zum Ausgleich von Frequenzdrift und/oder Toleranzen jeweils mehrere benachbarte Speicherplätze des zweiten Speichers (IS 15) übereinstimmende Adressen des ersten Speichers (IS 17) enthalten.

5. Anordnung nach einem der Ansprüche 1 bis 4, dadurch gekennzeichnet, daß die Oszillatorfrequenz des Empfängers einen die Umsetzungsmittel bildenden voreinstellbaren Zähler (IS 8 bis IS 10)

8

taktet, dessen binäre Ausgänge (pin 11 bis 14) während einer aus der Frequenz des Oszillators (G) über Frequenzteiler (IS 2 bis 4) abgeleiteten Zählzeit (Freigabezeit) über Speicherzellen (IS 11 bis 13) mit Adresseneingängen (pin 1 bis 8 und 19, 22, 23) des zweiten Speichers (IS 15) verbunden sind, an dessen Ausgänge (pin 9 bis 17) die Adresseneingänge (pin 1 bis 4 und 18, 19, 22, 23) des von einem binären Zähler (IS 14) gesteuerten ersten Speichers (IS 17) angeschlossen sind, der mit einem von dem binären Zähler (IS 14) und einem Demultiplexer (IS 16) gesteuerten Indikator (IS 18 bis 21) zur Anzeige der Sendernamen verbunden ist.

6. Anordnung nach Anspruch 5, dadurch gekennzeichnet, daß der Indikator (IS 18 bis 21) aus einem alphanumerischen LCD- und/oder LED-Indikator besteht.

7. Anordnung nach Anspruch 5 oder 6, dadurch gekennzeichnet, daß der Indikator (IS 18 bis 21) aus 5 × 7-Raster oder 14- bzw. 16-Segmentanzeigen besteht.

8. Anordnung nach einem der Ansprüche 1 bis 7, dadurch gekennzeichnet, daß alternativ zu den adressierten Speicherplätzen des ersten und/oder zweiten Speichers (IS 17 bzw. IS 15) die Inhalte von Speicherplätzen eines parallel adressierbaren Schreib-Lese- oder Festwert-Speichers (IS 24) auslesbar sind.

9. Anordnung nach Anspruch 8, dadurch gekennzeichnet, daß die Auswahl des Auslesens aus jeweils einem der parallel adressierbaren Speicher (IS 17 bzw. IS 15 und IS 24) durch den Inhalt des jeweils adressierten Speicherplatzes eines weiteren parallel adressierbaren Speichers und/oder eines manuell betätigbaren Schalters bestimmt wird.

## Claims

1. Circuit arrangement for the automatic indication of alphanumerical station designations in radio or TV receivers, by way of a first memory (IS 17) which contains information retained in its memory positions as station designations, means (IS 14, IS 16) for decoding and transferring the information to an indicator memory for the alphanumeric illustration, and a second memory (IS 15) for addressing the first memory (IS 17), wherein a numerical value derived from the currently set receiving frequency forms the address of the first memory (IS 17) at least on an indirect basis and the addressing of this second memory (IS 15) is facilitated by the status of a presettable counter (IS 8 through IS 10) which is pulsed for a respective given period of time by the oscillator frequency corresponding with the momentary receiving frequency of the receiver and which is reset after expiration of the period of time and wherein the presettable counter (IS 8 through IS 10) converts the oscillator frequencies in such a manner that the range of the oscillating numbers appearing in the given period of time corresponds with the range of the numerical values of the scheduled addresses of the second memory, characterized in that the data inputs (pin 3 through 6) of the presettable counter (IS 8 through IS 10) are connected with the outputs (pin 1 through pin 12) of a matrix (M) in which the value of the frequency to which the counter is to preset is retained for every frequency range whereby the preset is made in such a manner that the lowest frequency of the wave range corresponds to the binary value 0.

2. Arrangement of Claim 1 characterized in that the oscillating numbers appearing in a given period of time correspond with the range of numerical values of the planned addresses of the second memory (IS 15) for a given grid of receiving frequencies.

3. Arrangement of one of Claims 1 or 2 characterized in that for a receiver comprising serveral receiving frequency ranges, the addresses of the adressable ranges in the memory (IS 15 and/or IS 17) are located adjacent to each other essentially without gaps.

4. Arrangement of one of Claims 1 through 3 characterized in that several adjacent storage positions of the second memory (IS 15) contain concurring addresses of the first memory (IS 17) in order to equalize frequency drift and/or tolerances.

5. Arrangement of one of the Claims 1 through 4 characterized in that the oscillator frequency of the receiver pulses the presettable counter forming the converting means (IS 8 through IS 10), the binary outputs of which (pins 11 through 14) — during a counting period (approval period) derived from the frequency of the oscillator (G) via frequency dividers (IS 2 through 4) and — are connected with address inputs (pins 1 through 8 and 19, 22, 23) of the second memory (IS 15) via memory cells (IS 11 through 13), that the address inputs (pin 1 through 4 and 18, 19, 22, 23) of the first memory (IS 17 triggered by a binary counter (IS 14) are connected to the outputs (pins 9 through 17) of the second memory (IS 15), that the first memory (IS 17) is connected with an indicator (IS 18 through 21) for showing the station names which is triggered by one of the binary counters (IS 14) and a demultiplexer (IS 16).

6. Arrangement of Claim 8 characterized in that the indicator (IS 18 through 21) consists of an alphanumeric LCD or LED indicator.

7. Arrangement of Claims 5 or 6 characterized in that the indicator (IS 18 through 21) consists of 5 × 7 grid or 14 and/or 16 segment indications.

8. Arrangement of one of the Claims 1 through 7 characterized in that the contents of storage positions of a parallel addressable RAM or ROM (IS 24) are readable as an alternative to the addressed memory positions of the first and/or second memory (IS 17 and/or IS 15).

9

9. Arrangement of Claim 8, characterized in that the selection of reading from one of the parallel addressable memories (IS 17 and/or IS 15 and IS 24) is determined by the content of the respective addressed storage position of an additional parallel addressable memory and/or a manually operated switch.

## Revendications

1. Circuit d'indication automatique de désignations alphanumeriques des emetteurs pour radiorécepteurs ou récepteurs de télévision comprenant une première mémoire (IS 17), mémorisant dans ses positions de mémoire des informations des désignations d'émetteurs, des moyens (IS 14, IS 16) de décoder et de transmettre les informations dans une mémoire d'indication pour la représentation alphanumérique, et une seconde mémoire (IS 15) adressant la première mémoire, une valeur numérique dérivée de la fréquence d'entrée ajustée pour l'instant formant au moins indirect l'adresse de la première mémoire (IS 17) et l'adressation de la seconde mémoire (IS 15) étant réalisé par la position atteinte d'un compteur à préselecter qui est pulsé pendant une période déterminée par la fréquence de l'oscillateur correspondant à la fréquence dentrée momentanée et qui est remis à la fin de cette période, le compteur à préselecter (IS 8 à IS 10) convertissant la fréquence de l'oscillateur d'une telle manière que la plage des nombres des oscillations se manifestant pendant cette période correspond à la plage des valeurs numériques des adresses prévues de la première mémoire (IS 15) caractérisé en ce que le entrées des données du compteur à préselecter (IS 8 à IS 10) sont connectées avec les sorties d'une matrice (M), contenant la valeur de la fréquence pour chaque plage de fréquence dont le compteur est à préselecter, la préselection étant déterminée dans une telle manière que la fréquence la plus basse de la plage d'ondes correspond au nombre binaire 0.

2. Circuit selon la revendication 1 caractérisé en ce que pour les moyens de conversions (IS 8 à IS 10) les nombres des oscillations se manifestant pendant une période determinée corrrespondent à la plage des valeurs numériques des adresses prévues de la seconde mémoire (IS 15) pour un réseau déterminé de fréquences d'entrée.

3. Circuit selon de revendication 1 ou 2 caractérisé en ce que pour un récepteur avec plusieurs plages de fréquences d'entrée les adresses des domaines adressables dans la mémoire (IS 15 resp. IS 17) se touchent essentiellement sans lacune.

4. Circuit selon une des revendication 1 à 3, caractérisé en ce que pour compenser des drifts de fréquences et/ou tolérances plusieurs positions de mémoire voisines de la seconde mémoire (IS 15) ont des adresses concordants de la première mémoire (IS 17).

5. Circuit selon une des revendications 1 à 4, caractérisé en ce que la fréquence de l'oscillateur du récepteur pulse le compteur à préselecter (IS 8 à IS 10) formant les moyens de conversion, dont les sorties binaires (pin 11 à 14) sont connectées passant par des cellules-mémoire (IS 11 à IS 13) avec les entrées d'adresses (pin 1 à 8 et 19, 22, 23) de la seconde mémoire (IS 15) pendant un temps de compte dérivé à l'aide de diviseurs de fréquence (IS 2 à IS 4) de la fréquence de l'oscillateur et en ce que les sorties (pin 9 à 17) de la seconde mémoire (IS 15) sont connectées avec les entrées d'adresses (pin 1 à 4 et 18, 19, 22, 23) de la première mémoire (IS 14) contrôlée par un compteur binaire (IS 14), la première mémoire étant connectée avec un indicateur (IS 18 à 21) pour l'indication des noms d'émetteurs contrôlé par le compteur binaire (IS 14) et un démultiplexeur (IS 16).

6. Circuit selon la revendication 5 caractérisé en ce que l'indicateur (IS 17 à 21) est un LCD- et/ou LED indicateur alphanumérique.

7. Circuit selon la revendication 5 ou 6, caractérisé en ce que l'indicateur (IS 18 à 21) est une $5 \times 7$ trame ou un indicateur à 14 ou 16 segments.

8. Circuit selon une des revendications 1 à 7, caractérisé en ce que comme alternative aux positions de mémoire adressées de la première et/ou seconde mémoire (IS 17 resp. IS 15) les contenus des positions de mémoire d'une mémoire à accès aléatoire ou à lecture adressable parallèlement sont extraits.

9. Circuit selon la revendication 8 caractérisé en ce que le choix d'extraire les données d'une des mémoires adressables parallèlement (IS 17 resp. IS 15 et IS 24) est déterminé par le contenu de la position de mémoire adressée d'une autre mémoire adressable parallèlement et/ou par un interrup-teur à commande manuelle.

Fig. 1a

Fig. 1b

Fig. 2

0 065 552